Europäisches Patentamt

European Patent Office

Office européen des brevets

(11) Numéro de publication: **0 483 003 B1**

## FASCICULE DE BREVET EUROPEEN

(45) Date de publication de fascicule du brevet: **01.03.95**    (51) Int. Cl.⁶: **C09K 11/79**, H01S 3/16, C30B 15/00

(21) Numéro de dépôt: **91402828.7**

(22) Date de dépôt: **23.10.91**

(54) **Emetteur laser constitué d'un silicate mixte d'yttrium et de lanthanide.**

(30) Priorité: **25.10.90 FR 9013231**

(43) Date de publication de la demande:
**29.04.92 Bulletin 92/18**

(45) Mention de la délivrance du brevet:
**01.03.95 Bulletin 95/09**

(84) Etats contractants désignés:
**CH DE GB IT LI NL**

(56) Documents cités:
**EP-A- 0 253 589**
**US-A- 3 632 523**
**US-A- 3 710 278**

(73) Titulaire: **COMMISSARIAT A L'ENERGIE ATO-MIQUE**
**31-33, rue de la Fédération**
**F-75015 Paris (FR)**

(72) Inventeur: **Faure, Christian**
**22, rue des Bonnais**
**F-38120 Saint Egreve (FR)**
Inventeur: **Moncorge, Richard**
**54 Grand Rue**
**F-01600 Trevoux (FR)**
Inventeur: **Romero, Roselyne**
**5, rue Beyle Standhal**
**F-38360 Sassenage (FR)**
Inventeur: **Wyon, Christophe**
**5 rue du Drac**
**F-38120 Saint Egreve (FR)**

(74) Mandataire: **Mongrédien, André et al**
**c/o BREVATOME**
**25, rue de Ponthieu**
**F-75008 Paris (FR)**

## Description

La présente invention a pour objet des émetteurs lasers constitués de silicates mixtes d'yttrium et de lanthanide monophasés, obtenus en particulier sous forme de monocristaux. Elle trouve une application dans le domaine des microlasers pour l'optique intégrée, les télécommunications par fibres optiques, la médecine (microchirurgie, traitement de la peau et des yeux), l'étude des semi-conducteurs et la recherche scientifique (spectroscopie des molécules organiques et des matériaux) ainsi que dans le domaine des lasers de puissance pour effectuer des analyses à distance de l'atmosphère, des communications spatiales.

Ces lasers émettent à température ambiante dans la zone de sécurité occulaire autour de 1,55 et de $2\mu$m. Ils présentent un certain degré d'accordabilité en longueur d'onde.

De façon connue, des émetteurs lasers délivrant une longueur d'onde voisine de 1,55$\mu$m peuvent être obtenus par le dopage par des ions $Er^{3+}$ d'une matrice transparente à cette longueur d'onde : cristal ou verre. La transition entre l'état excité $^4I_{13/2}$ et l'état fondamental $^4I_{15/2}$ des ions $Er^{3+}$ conduit à un laser à 3 niveaux. La longueur d'onde émise par cette transition, à température ambiante, dépend fortement de l'environnement cristallographique des ions $Er^{3+}$, comme le montre le tableau I ci-joint.

Des lasers accordables autour de $2\mu$m, fonctionnant à température ambiante, ont déjà été réalisés à partir de matériaux lasers bien connus :

$Y_3Al_5O_{12}$, $Y_3Sc_2Ga_3O_{12}$, $YAlO_3$, $LiYF_4$

dopés avec des ions $Tm^{3+}$ et/ou $Ho^{3+}$. Ces lasers utilisent respectivement les transitions électroniques entre le niveau $^3F_4$ et le niveau fondamental $^3H_6$ des ions $Tm^{3+}$ et entre le niveau $^5I_7$ et le niveau fondamental $^5I_8$ des ions $Ho^{3+}$ ; ce sont donc des lasers à 3 niveaux pour lesquels la population du niveau fondamental à température ambiante joue un rôle prépondérant.

Une propriété très importante des ions $Er^{3+}$, $Ho^{3+}$ et $Tm^{3+}$ est la forte probabilité de transferts d'énergie entre ces ions excités qui conduit aux processus de relaxation croisée et de conversion vers le haut ("Cross-relaxation" et "up-conversion" en terminologie anglo-saxonne) limitant souvent l'efficacité laser des transitions dans l'infrarouge.

Il est ainsi possible d'obtenir un laser émettant de la lumière verte à partir des monocristaux de $YAlO_3$, $Y_3Al_5O_{12}$, $Y_3Sc_2Ga_3O_{12}$, $LiYF_4$ ou $YF_3$ dopés par les ions $Er^{3+}$ et un laser émettant dans le bleu à partir de cristaux de $LiYF_4$ dopés avec des ions $Tm^{3+}$ lorsque les monocristaux sont pompés dans le proche infrarouge. Il est alors évident que le rendement des émissions stimulés infrarouges caractéristiques de ces ions autour de 1,55 et de $2\mu$m s'en trouve notablement affecté.

Les verres et les fibres de silice dopés $Er^{3+}$ semblent remédier en partie aux inconvénients des matériaux monocristallins précédemment cités. Outre le fait que ces matrices dopées $Er^{3+}$ présentent une émission stimulée dans la gamme de sécurité occulaire maximale (tableau I), les vertes et les fibres présentent une forte densité de phonons, ce qui permet de dépeupler les niveaux électroniques des ions $Er^{3+}$, éventuellement peuplés par transferts d'énergie entre ces ions, par des processus de relaxation non radiative. Hélas les propriétés thermomécaniques, la conductivité thermique notamment, des verres et des fibres, beaucoup plus faibles que celles des matériaux monocristallins ci-dessus, ne sont pas suffisantes pour permettre la construction d'un laser de forte puissance moyenne.

Aussi, La réalisation d'un laser de puissance émettant autour de 1,55 et de $2\mu$m passe nécessairement par l'utilisation dans la cavité laser d'un matériau monocristallin (pour ses bonnes propriétés thermomécaniques) susceptible d'être dopé par des ions $Er^{3+}$, $Tm^{3+}$ et $Ho^{3+}$ et ne présentant pour ces dopages qu'une très faible probabilité de transfert d'énergie entre ces ions.

Une des solutions pour minimiser voire même éliminer ces transferts d'énergie est d'isoler les ions actifs $Er^{3+}$, $Ho^{3+}$ et $Tm^{3+}$ les uns des autres en utilisant des matrices hôtes à base de groupements anion-cation très volumineux tels que les silicates. De plus, les silicates ont, comme les verres et les fibres, la propriété de présenter des densités de phonons importantes. De ce fait, les niveaux électroniques des ions actifs éventuellement peuplés par "cross-relaxation" et/ou par "up-conversion" se désexcitent préférentiellement par des processus de relaxations non radiatives assistées par phonons, jusqu'au niveau supérieur de la transition laser dans l'infrarouge, ce qui augmente d'autant le rendement des émissions stimulées autour de 1,5 et $2\mu$m.

Parmi les silicates, les monocristaux d'oxyorthosilicate d'yttrium $Y_2SiO_5$, ci-après dénommés YSO, dopés par une terre rare présentent des propriétés luminescentes tout à fait intéressantes.

Les propriétés luminescentes des ions $Ho^{3+}$ dans les monocristaux de YSO codopés $Er^{3+}$ et codopés $Er^{3+}$ et $Tm^{3+}$ ont déjà été étudiées par A.M. Morozov et al. (Opt. Spectrosc., vol. 41, 6 (76), p. 641-642) et ont été utilisées pour réaliser un laser pompé par des lampes flash autour de 2,1$\mu$m qui ne fonctionne que pour T<220K.

Pour accroître le rendement de pompage et par là même le rendement global du laser à base d'ions actifs $Ho^{3+}$, les monocristaux des YSO sont codopés avec des ions $Er^{3+}$ et $Tm^{3+}$ afin d'augmenter le coefficient d'absorption moyen de ce matériau dans la zone d'émission des lampes. Les ions $Er^{3+}$ et $Tm^{3+}$ sont utilisés comme sensibilisateurs de l'émission stimulée des ions $Ho^{3+}$ effectivement actifs. Ces codopages ont également été étudiés dans les cristaux de YAG et de $LiYF_4$, (E.P. Chicklio et al., IEEE J. of Quant. Electr., vol. QE 8, 2 (1972), p. 225-234).

Les ions $Er^{3+}$ et $Tm^{3+}$ sont en fait des intermédiaires entre la lumière de pompe émise par les lampes et les ions $Ho^{3+}$ seuls responsables de l'émission stimulée autour de 2,1$\mu$m. La probabilité de transfert d'énergie entre les ions $Er^{3+}$ et $Tm^{3+}$ d'une part et les ions $Ho^{3+}$ d'autre part est très importante ; aucune émission stimulée à partir des ions $Er^{3+}$ et $Tm^{3+}$ n'a été observée par A.M. Morozov.

Par ailleurs, on a réalisé des cristaux de YSO dopés avec des ions $Nd^{3+}$ présentant une émission stimulée efficace à 0,912 et 1,075$\mu$m comme décrit dans l'article de K.S. Bagdasarov et al, Sov. PHys. Dokl., vol 18, 10 (74), p. 664.

L'invention a pour objet de nouveaux émetteurs lasers constitués de silicates mixtes d'yttrium et de lanthanide monophasés, en particulier monocristallins, qui permettent notamment de remédier aux différents inconvénients mentionnés ci-dessus. En particulier, ces silicates présentent une émission stimulée efficace à température ambiante utilisable dans des lasers de forte puissance moyenne émettant dans l'infrarouge.

De façon plus précise, l'invention a pour objet un émetteur laser constitué d'un silicate mixte d'yttrium et de lanthanide monophasé, présentant la formule (II) suivante:

$$Y_{2-2x-2y}Er_{2x}Yb_{2y}SiO_5$$

dans laquelle x et y sont des nombres tels que $O<x\leqq0,15$ et $0\leqq y\leqq0,2$.
ou la formule (III) suivante :

$$Y_{2-2x}Tm_{2x}SiO_5 \qquad (III)$$

dans laquelle x est un nombre tel que $0<x\leqq0,2$.

Les silicates mixtes d'yttrium dopés répondant aux formules (II) et (III) peuvent être réalisés aisément sous forme de monocristaux par les méthodes classiques de tirage à partir d'un bain fondu telles que la méthode de Czochralski ou de Bridgman.

Les rayons ioniques des ions $Er^{3+}$ et $Tm^{3+}$ sont proches de ceux des ions $Y^{3+}$ et le coefficient de ségrégation de ces ions lanthanides est proche de 1 ; la fusion de ces silicates est dite congruente. Ceci facilite la croissance cristalline de ces silicates permettant ainsi l'obtention de cristaux de grande dimensions de bonne qualité par la méthode Czochralski utilisée industriellement pour la fabrication des lasers de puissance.

Les propriétés thermomécaniques du YSO et en particulier la conductivité thermique se rapprochent plus de celles du grenat d'yttrium et d'aluminium de formule $Y_3Al_5O_{12}$ que de celles des verres. Cette bonne conductivité thermique permet une bonne évacuation de la chaleur du monocristal émetteur, ce qui est nécessaire pour la réalisation d'un laser de puissance.

Les lasers utilisant les monocristaux des silicates de l'invention peuvent être pompés optiquement par des lampes ou une ou plusieurs diodes lasers. De préférence, on utilise des diodes lasers pour le pompage optique. En effet, ces diodes lasers ont l'avantage d'être extrêmement petites, diminuant de façon considérable les dimensions totales du laser. En outre, elles offrent une certaine accordabilité en longueurs d'onde et un rendement excellent, ce qui améliore le rendement de l'effet laser à partir du courant électrique par rapport à un pompage par lampe.

Dans les silicates mixtes de l'invention, l'activateur laser est l'ion $Er^{3+}$ ou $Tm^{3+}$ et le sensibilisateur laser est l'ion $Yb^{3+}$.

Les silicates mixtes d'yttrium et de lanthanide présentant la formule (II) sont monophasés et destinés à être fabriqués sous forme monocristalline pour la réalisation de lasers émettant dans l'infrarouge autour de 1,55$\mu$m avec une certaine accordabilité.

Excités à l'aide d'une diode laser, les monocristaux de YSO:$Er^{3+}$ se caractérisent notamment par une bande de fluorescence large de 1,45 à 1,7$\mu$m avec un maximum de fluorescence autour de 1,545$\mu$m, zone de sécurité occulaire maximale.

La durée de vie de l'état excité $^4I_{13/2}$ d'un monocristal de YSO de formule (I) pour $x=0,1$ et $y=0$ est égale à 9,2ms, ce qui permet de stocker une énergie considérable lorsque ces cristaux sont pompés à l'aide de lampes au xénon ou au krypton, de diodes lasers émettant soit vers 0,79$\mu$m, soit vers 0,98$\mu$m ou

encore vers 1,45-1,48$\mu$m.

Selon l'invention, le taux de dopage en ions Er$^{3+}$ varie de x = 0,003, pour le pompage par une diode laser vers 1,45-1,48$\mu$m, à x = 0,15, pour le pompage par lampes. L'optimal se situe pour des valeurs de x variant de 0,01 à 0,03.

Le codopage à l'ytterbium selon l'invention permet d'accroître l'efficacité de pompage des lasers à base de YSO:Er lorsque ces derniers sont pompés à l'aide d'une diode laser émettant à 0,79 ou 0,98$\mu$m ou de lampes. Ce codopage, déjà utilisé dans les verres phosphatés dopés Er$^{3+}$, a l'avantage d'associer aux bandes d'absorption fines des ions Er$^{3+}$ une bande d'absorption large autour de 0,99$\mu$m susceptible d'être peuplée soit par désexcitation non radiative des niveaux supérieurs des ions Er$^{3+}$, soit par pompage à l'aide d'une diode laser à 0,98$\mu$m. Le taux de codopage par l'ytterbium peut aller de y = 0,08 à y = 0,2, lorsque ce codopage est utilisé.

Lorsque les silicates mixtes d'yttrium-thulium de formule (III) sont réalisés sous forme de monocristaux et placés dans une cavité laser, ils présentent une bande de fluorescence très intense et très large de 1,5 à 2,1$\mu$m avec plusieurs maxima vers 1,72, 1,8, 1,94 et 2,02$\mu$m lorsqu'ils sont excités à l'aide d'une diode laser à 0,79$\mu$m. La durée de vie du niveau émetteur $^{3}F_4$ de l'émission stimulée est égale à 1,3ms pour un cristal de formule (III) avec x = 0,1 et y = 0, ce qui permet de stocker une énergie importante dans ce niveau lorsque ce cristal est pompé à l'aide de lampes ou de diodes lasers.

L'émission stimulée d'un laser à base de YSO:Tm pompé par lampes ou par diode laser est accordable continûment de 1,7 à 2,05$\mu$m à température ambiante.

Les émetteurs lasers de l'invention émettant dans l'infrarouge, dans la zone de sécurité oculaire, à température ambiante, l'invention a encore pour objet un laser comportant une cavité laser renfermant comme émetteur de lumière un monocristal, des moyens d'amplification de la lumière issue du monocristal, des moyens de sortie de la lumière hors de la cavité laser et des moyens de pompage optique, caractérisé en ce que le monocristal présente la formule (I) suivante :

$$Y_{2-2x-2y}M_{2x}Yb_{2y}SiO_5 \qquad (I)$$

dans laquelle M représente un lanthanide choisi parmi l'erbium et le thulium et x et y représentent des nombres tels que $0 < x \leq 0{,}2$ et $0 \leq y \leq 0{,}2$.

Ce laser est en particulier un laser accordable en longueurs d'onde et comporte par conséquent des moyens d'accordabilité.

D'autres caractéristiques et avantages de l'invention ressortiront mieux de la description qui va suivre, donnée à titre illustratif et non limitatif, en référence aux dessins annexés, dans lesquels :
- la figure 1 représente schématiquement un laser de puissance fonctionnant en continu, conforme à l'invention, pompé par une diode laser, et
- la figure 2 représente schématiquement un laser de puissance conforme à l'invention pompé par lampes.

On décrit ci-après la fabrication d'un monocristal d'un silicate conforme à l'invention par la technique de croissance Czochralski. Pour ce faire, des poudres du commerce, de haute pureté, des oxydes d'yttrium, de silicium, d'erbium ou de thulium et éventuellement d'ytterbium sont pesées dans les proportions désirées puis mélangées et calcinées à 1500°C. Le mélange de poudres ainsi obtenu est alors placé dans un creuset d'iridium ; il est ensuite porté à la température de fusion voisine de 2100°C, à l'abri de l'oxygène de l'air, de manière à former un bain fondu.

Il est aussi possible de former ce bain fondu en partant d'un coprécipité d'hydroxyde, dans un solvant aqueux ou non, des ions Y$^{3+}$, Si$^{4+}$, Er$^{3+}$ ou Tm$^{3+}$ et éventuellement Yb$^{3+}$. Le coprécipité peut être obtenu par action de l'ammoniac sur des nitrates ou chlorures des différents éléments métalliques, disponibles dans le commerce. Le coprécipité obtenu est ensuite traité à 400°C en atmosphère ventilée jusqu'à déshydratation complète puis calciné à 1500°C. Le produit obtenu est alors placé dans un creuset d'iridium pour former le bain fondu.

Un germe monocristallin de même composition que le bain fondu et par exemple taillé parallèlement à la direction $\underline{b}$ de la maille cristalloraphique est alors amené au contact du bain puis remonté vers le haut tout en étant animé d'un mouvement de rotation sur lui-même. Le monocristal est ainsi formé progressivement au bout du germe selon la direction imposée par celui-ci. La vitesse de tirage est choisie de 0,3 à 2 mm/h et la vitesse de rotation est choisie de 5 à 40 tours/minute.

Le tableau II annexé donne des exemples de monocristaux de silicates de l'invention obtenus par la méthode Czochralski à partir des poudres d'oxyde des différents ions.

La partie gauche de ce tableau donne la composition en mole% initiale à partir de laquelle ont été fabriqués les monocristaux et la partie droite de ce tableau donne la formule du cristal obtenu.

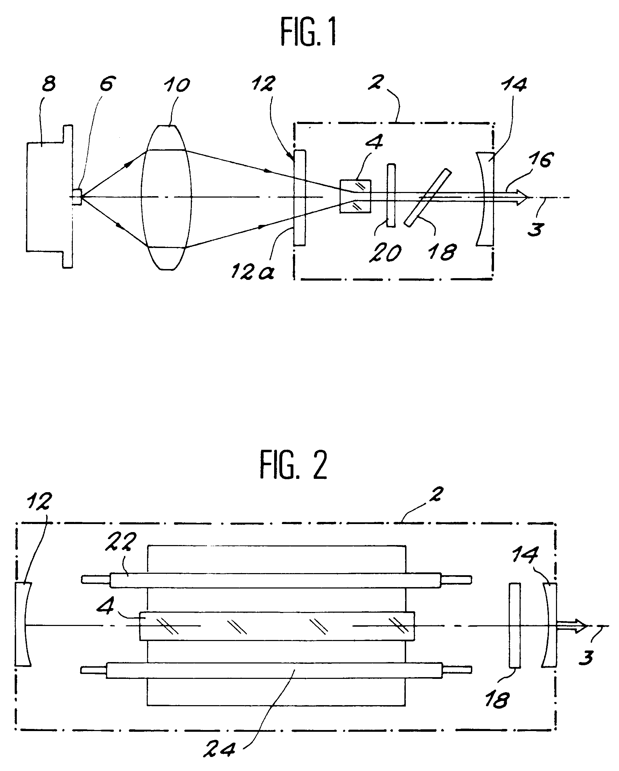

Sur la figure 1, on a représenté schématiquement un laser de puissance, continu utilisant un monocristal d'un silicate conforme à l'invention.

Ce laser comprend une cavité laser 2 contenant un barreau 4 d'un silicate de l'invention. Une diode laser 6 supportée par un élément dissipateur de chaleur 8 permet d'irradier le barreau 4, via une lentille de convergence 10 et assurer ainsi le pompage optique du barreau 4. Un dispositif de refroidissement du barreau 4 du type à circulation d'eau peut être prévu autour de ce dernier.

La cavité laser 2 se compose d'un miroir d'entrée 12 dichroïque, placé à proximité du barreau 4 et d'un miroir de sortie 14. Le miroir d'entrée 12 est transparent à la lumière émise par la diode laser 6 et opaque à celle émise par le monocristal 4. Le miroir 14 de sortie est quant à lui partiellement transparent à la lumière émise par le monocristal 4.

L'excitation du barreau 4 conduit à une émission stimulée de ce dernier qui est réfléchie sur le miroir 14 puis traverse à nouveau le barreau 4 où elle est amplifiée. Le faisceau laser amplifié est alors réfléchi par le miroir 12 vers le barreau 4 et ainsi de suite.

Le faisceau laser 16 suffisamment amplifié dans la cavité laser 2 sort par le miroir 14 selon l'axe 3.

L'accordabilité en longueurs d'onde peut être obtenue à l'aide d'un système de sélection en longueurs d'onde 18, intercalé entre le barreau 4 et le miroir de sortie 14, du type prisme à angle de Brewster ou un filtre de Lyot formé de plusieurs lames en matériau biréfringent. En outre, un étalon solide 20, du type lame à faces parallèles, peut être intercalé entre le barreau 4 et le sélecteur d'ondes 18 pour fixer la longueur d'onde d'émission.

Il est aussi possible d'utiliser les silicates de l'invention dans un laser de puissance tel que représenté sur la figure 2.

La cavité 2 de ce laser comporte comme précédemment un miroir d'entrée 12, un miroir de sortie 14 et un barreau 4 d'un silicate monocristallin de l'invention. De part et d'autre du barreau 4 sont disposées des lampes à gaz 22 et 24 et en particulier des lampes flash au xénon ou au krypton, de forte intensité. Ces lampes présentent une forme allongée et sont orientées parallèlement à l'axe 3 du laser pour assurer un pompage optique longitudinal du barreau 4. Un dispositif de circulation d'eau autour du barreau 4 peut être prévu pour assurer son refroidissement.

La cavité laser 2 comprend en outre un sélecteur en longueurs d'onde 18 lorsque l'on souhaite un laser accordable en longueurs d'onde.

EXEMPLE 1

Une plaquette de 5mm d'épaisseur a été découpée dans le monocristal n°1 du tableau II, perpendiculairement à l'axe $\underline{b}$ de tirage, puis polie. Un barreau de diamètre 5mm est ensuite carotté selon l'axe $\underline{b}$ puis placé dans une cavité laser 2 semblable à celle représentée sur la figure 1.

Le barreau est pompé à l'aide d'une diode laser 6 émettant soit vers 0,79-0,80$\mu$m, soit vers 0,97-0,98$\mu$m ou soit vers 1,45-1,48$\mu$m ; la face 12a du miroir d'entrée 12 doit être traitée antireflet pour l'une ou l'autre de ces longueurs d'onde.

La réflectivité R1 du miroir d'entrée à 1,56$\mu$m doit être maximale, soit R1≧99,8%, alors que celle du miroir de sortie, notée R2, varie entre 95 et 99%.

Le faisceau laser 16 délivré par cette cavité a une longueur d'onde de 1,56$\mu$m et est monomode ; sa puissance de sortie dépend linéairement de la puissance émise par la diode laser.

Avantageusement, les faces du barreau 4 parallèles au miroir 12 sont traitées antireflet à 1,56$\mu$m.

EXEMPLE 2

Un barreau dont le diamètre peut varier entre 4 et 10mm et dont la longueur est imposée par la longueur utile de monocristal élaboré est carotté selon l'axe $\underline{b}$ dans l'échantillon n°3. Les deux faces du barreau sont alors polies, en respectant un très bon parallélisme, puis traitées antireflet à 1,56$\mu$m. Ce barreau est placé dans une cavité du type de celle représentée sur la figure 2 et pompé à l'aide de lampes 22, 24 continues ou pulsées au xénon ou au krypton.

La réflectivité R1 du miroir d'entrée 12 est maximale à 1,56$\mu$m, soit R1≧99,8% alors que celle du miroir de sortie R2 peut varier entre 95 et 99%.

L'énergie ou la puissance de sortie de ce laser à 1,56$\mu$m varie linéairement avec l'énergie ou la puissance émise par les lampes.

EXEMPLE 3

Une plaquette d'épaisseur 5mm est découpée perpendiculairement à l'axe de tirage b du cristal n°5, puis polie. Un barreau de diamètre 5mm est ensuite carotté selon l'axe b et traité antireflet dans la zone 1,7-2,05μm. Ce barreau est alors placé dans une cavité 2 identique à celle représentée sur la figure 1, et pompé à l'aide d'une diode laser émettant à 0,791μm.

La face 12a du miroir d'entrée est traitée antireflet à 0,791μm. La réflectivité R1 du miroir d'entrée 12 dans la gamme d'accordabilité du laser entre 1,7 et 2,05μm doit être maximale, soit R1≧99,8% alors que celle du miroir de sortie R2 peut varier entre 92 et 99% dans la même gamme de longueurs d'onde.

L'accordabilité du faisceau laser entre 1,7 et 2,05μm est réalisée grâce à la lame étalon 20 et/ou un filtre de Lyot 18 eux-mêmes traités antireflet entre 1,7 et 2,1μm.

La puissance délivrée par ce laser varie linéairement avec la puissance émise par la diode laser et est maximale autour de 1,7-1,96μm.

**T A B L E A U   I**

| Matrice d'acceuil des ions $Er^{3+}$ | Verres phosphatés | Fibres $SiO_2$ | $Y_3Al_5O_{12}$ |
|---|---|---|---|
| Longueur d'onde de $^4I_{13/2} \rightarrow {}^4I_{15/2}$ à $T=300\ K$ (µm) | 1,54 | 1,53 – 1,57 | 1,64 |

**T A B L E A U   II**

| Ex. | Y$_2$O$_3$ | SiO$_2$ | Er$_2$O$_3$ | Yb$_2$O$_3$ | Tm$_2$O$_3$ | Cristal obtenu |
|---|---|---|---|---|---|---|
| | Composition initiale (mole%) | | | | | |
| 1 | 49,5 | 50 | 0,5 | | | $Y_{1,98}Er_{0,02}SiO_5$ |
| 2 | 42,5 | 50 | 7,5 | | | $Y_{1,70}Er_{0,30}SiO_5$ |
| 3 | 44,75 | 50 | 0,25 | 5 | | $Y_{1,79}Er_{0,01}Yb_{0,2}SiO_5$ |
| 4 | 39,875 | 50 | 0,125 | 10 | | $Y_{1,595}Er_{0,005}Yb_{0,4}SiO_5$ |
| 5 | 47 | 50 | | | 3 | $Y_{1,88}Tm_{0,12}SiO_5$ |
| 6 | 44 | 50 | | | 6 | $Y_{1,76}Tm_{0,24}SiO_5$ |
| 7 | 40 | 50 | | | 10 | $Y_{1,6}Tm_{0,4}SiO_5$ |

**Revendications**

1. Emetteur laser constitué d'un silicate mixte d'yttrium et de lanthanide monophasé, présentant la formule (II) suivante :

7

$Y_{2-2x-2y}Er_{2x}Yb_{2y}SiO_5$

dans laquele x et y sont des nombres tels que $0<x\leq0,15$ et $0\leq y\leq0,2$.

2. Emetteur laser selon la revendication 1, caractérisé en ce que x satisfait à l'équation $0,005\leq x\leq0,15$.

3. Emetteur laser selon la revendication 1 ou 2, caractérisé en ce que x satisfait à l'équation $0,01\leq x\leq0,03$.

4. Emetteur laser selon l'une quelconque des revendications 1 à 3, caractérisé en ce que y satisfait à l'équation $0,08\leq y\leq0,2$.

5. Emetteur laser selon la revendication 1, caractérisé en ce que le silicate présente la formule $Y_{1,98}Er_{0,02}SiO_5$.

6. Emetteur selon la revendication 1, caractérisé en ce que le silicate présente la formule $Y_{1,74}Er_{0,06}Yb_{0,20}SiO_5$.

7. Emetteur laser constitué d'un silicate mixte d'yttrium et de lanthanide monophasé, présentant la formule (III) suivante :

$Y_{2-2x}Tm_{2x}SiO_5$     (III)

dans laquelle x est un nombre tel que $0<x\leq0,2$.

8. Emetteur selon la revendication 7, caractérisé en ce que x satisfait à l'équation $0,005\leq x\leq0,2$.

9. Emetteur selon la revendication 7, caractérisé en ce que le silicate présente la formule $Y_{1,76}Tm_{0,24}SiO_5$.

10. Laser comportant une cavité laser (2) renfermant comme émetteur de lumière un monocristal (4), des moyens d'amplification (12, 14) de la lumière issue du monocristal, des moyens de sortie (14) de la lumière hors de la cavité laser et des moyens de pompage optique (6, 22, 24), caractérisé en ce que le monocristal présente la formule (I) suivante :

$Y_{2-2x-2y}M_{2x}Yb_{2y}SiO_5$     (I)

dans laquelle M représente un lanthanide choisi parmi l'erbium et le thulium et x et y représentent des nombres tels que $0<x\leq0,2$ et $0\leq y\leq0,2$.

11. Laser selon la revendication 10, caractérisé en ce que les moyens de pompage (6) consistent en au moins une diode laser.

12. Laser selon la revendication 10 ou 11, accordable en longueurs d'onde dans l'infrarouge, caractérisé en ce qu'il comporte des moyens d'accordabilité et en ce que M représente Tm avec $0<x\leq0,2$ et $y=0$.

13. Laser selon la revendication 10 ou 11, émettant à $1,55\mu m$, caractérisé en ce que M représente Er avec $0<x\leq0,15$ et $0\leq y\leq0,2$.

## Claims

1. Laser emitter constituted by a mixed monophase yttrium and lanthanide silicate of the following formula (II):

$Y_{2-2x-2y}Er_{2x}Yb_{2y}SiO_5$

in which x and y are numbers such that $0<x\leq0.15$ and $0\leq y\leq0.2$.

EP 0 483 003 B1

2. Laser emitter according to claim 1, characterized in that x satisfies the equation $0.005 \leq x \leq 0.15$.

3. Laser emitter according to claim 1 or 2, characterized in that x satisfies the equation $0.01 \leq x \leq 0.03$.

4. Laser emitter according to any one of the claims 1 to 3, characterized in that y satisfies the equation $0.08 \leq y \leq 0.2$.

5. Laser emitter according to claim 1, characterized in that the silicate is of formula $Y_{1.98}Er_{0.02}SiO_5$.

6. Laser emitter according to claim 1, characterized in that the silicate is of formula $Y_{1.74}Er_{0.06}Yb_{0.20}SiO_5$.

7. Laser emitter constituted by a mixed monophase yttrium and lanthanide silicate having the following formula (III):

$$Y_{2-2x}Tm_{2x}SiO_5 \qquad (III)$$

in which x is a number such that $0 < x \leq 0.2$.

8. Emitter according to claim 7, characterized in that x satisfies the equation $0.005 \leq x \leq 0.2$.

9. Emitter according to claim 7, characterized in that the silicate is of formula $Y_{1.76}Tm_{0.24}SiO_5$.

10. Laser having a laser cavity (2) containing as the light emitter a monocrystal (4), means (12, 14) for amplifying the light from the monocrystal, means (14) for removing light from the laser cavity and optical pumping means (6, 22, 24), characterized in that the monocrystal has the following formula (I):

$$Y_{2-2x-2y}M_{2x}Yb_{2y}SiO_5 \qquad (I)$$

in which M represents a lanthanide chosen from among erbium and thulium and x and y have numbers such that $0 < x \leq 0.2$ and $0 \leq y \leq 0.2$.

11. Laser according to claim 10, characterized in that the pumping means (6) comprise at least one laser diode.

12. Laser according to claim 10 or 11 which is wavelength tuneable in the infrared, characterized in that it has tuneability means and in that M represents Tm with $0 < x \leq 0.2$ and $y = 0$.

13. Laser according to claim 10 or 11, emitting at 1.55 $\mu$m, characterized in that M represents Er with $0 < x \leq 0.15$ and $0 \leq y \leq 0.2$.

**Patentansprüche**

1. Laseremitter, gebildet durch ein einphasiges Mischsilikat aus Yttrium und Lanthanid, das folgende Formel (II) aufweist:

$$Y_{2-2x-2y}Er_{2x}Yb_{2y}SiO_5$$

in der x und y Zahlen sind wie $0 < x \leq 0,15$ und $0 \leq y \leq 0,2$.

2. Laseremitter nach Anspruch 1, dadurch gekennzeichnet, daß x die Gleichung $0,005 \leq x \leq 0,15$ erfüllt.

3. Laseremitter nach Anspruch 1 oder 2, dadurch gekennzeichnet, daß x die Gleichung $0,01 \leq x \leq 0,03$ erfüllt.

4. Laseremitter nach einem der Ansprüche 1 bis 3, dadurch gekennzeichnet, daß y die Gleichung $0,08 \leq y \leq 0,2$ erfüllt.

9

**5.** Laseremitter nach Anspruch 1, dadurch gekennzeichnet, daß das Silikat die Formel $Y_{1,98}ER_{0,02}SiO_5$ aufweist.

**6.** Emitter nach Anspruch 1, dadurch gekennzeichnet, daß das Silikat die Formel $Y_{1,74}ER_{0,06}Yb_{0,20}SiO_5$ aufweist.

**7.** Laseremitter, gebildet durch ein einphasiges Yttrium- und Lanthanide-Mischsilikat, das folgende Formel (III) aufweist:

$$Y_{2-2x}Tm_{2x}SiO_5 \qquad (III)$$

in der x eine Zahl wie $0 < x \leq 0,2$ ist.

**8.** Emitter nach Anspruch 7, dadurch gekennzeichnet, daß x die Gleichung $0,005 \leq x \leq 0,2$ erfüllt.

**9.** Emitter nach Anspruch 7, dadurch gekennzeichnet, daß das Silikat die Formel $Y_{1,76}Tm_{0,24}SiO_5$ aufweist.

**10.** Laser, umfassend einen Laserresonator (2), der einen lichtemittierenden Monokristall (4) einschließt, Verstärkungseinrichtungen (12, 14) des vom Monokristall ausgehenden Lichts, Austrittseinrichtungen (14) des Lichts aus dem Laserresonator und Einrichtungen für optisches Pumpen (6, 22, 24), **dadurch gekennzeichnet,** daß der Monokristall die folgende Formel (I) aufweist:

$$Y_{2-2x-2y}M_{2x}Yb_{2y}SiO_5 \qquad (I)$$

in der M ein Lanthanid darstellt, gewählt zwischen Erbium und Thulium, und x und y Zahlen wie $0 < x \leq 0,2$ und $0 \leq y \leq 0,2$ darstellen.

**11.** Laser nach Anspruch 10, dadurch gekennzeichnet, daß die Einrichtungen zum optischen Pumpen aus wenigstens einer Laserdiode bestehen.

**12.** Laser nach Anspruch 10 oder 11, wellenlängenmäßig abstimmbar im Infrarotbereich, dadurch gekennzeichnet, daß er Abstimmeinrichtungen umfaßt und dadurch, daß M Tr darstellt mit $0 < x \leq 0,2$ und $y = 0$.

**13.** Laser nach Anspruch 10 oder 11, mit $1,55 \mu m$ emittierend, dadurch gekennzeichnet, daß M Er darstellt mit $0 < x \leq 0,15$ und $0 \leq y \leq 0,2$.

# FIG.1

# FIG. 2